# EUROPEAN PATENT APPLICATION

(11) **EP 4 202 750 A1**
(43) Date of publication of application: **28.06.2023**
(21) Application number: 21216670.6
(22) Date of filing: 21.12.2021
(51) Int. Cl.: G06F 30/12, G06F 30/13

(54) **3D MODEL GENERATION**

(71) Applicant: The West Retail Group Limited, Barton-upon-Humber North Lincolnshire DN18 5RL (GB)
(72) Inventor: FISHER, Katherine, Barton On Humber DN18 5RX (GB); LAVILLE, Conor, Barton On Humber DN18 5RX (GB); YULL, Jamie, Barton On Humber DN18 5RX (GB)
(74) Representative: Haseltine Lake Kempner LLP

(57) **Abstract**

A 3D model generation system comprising at least one computer, wherein: a procedural-rule generation application is configured to run on a given computer of the system; a model generation application is configured to run on said given computer or on another computer of the system; the procedural-rule generation application is configured, at runtime, to: receive portions of a source 3D model of a given object type; receive position information defining intended relative positions of those portions in a target 3D model of the given object type; receive or specify scaling rules associated with the portions, for scaling one or more of the respective portions when located in their intended relative positions to generate the target 3D model such that it has a target size whose value is an input parameter; and generate procedural rules, based on the portions, position information and scaling rules, for generation of the target 3D model based on a given value of the target size; and the model generation application is configured, at runtime, to: receive the procedural rules and an input value of the target size; and based on the received procedural rules and the input value, generate the target 3D model having the input value of the target size by procedural generation, wherein each said 3D model and portion of a 3D model is defined as a mesh of polygons.

## Description

The present invention relates to three-dimensional (3D) model generation, in particular where the models are 3D computer graphics models of elements of a room such as a kitchen. The present invention relates to associated computer systems, methods and software.

### BACKGROUND

The process of designing a room of a building, such as a kitchen, includes making selections of several different types of component or element, often from a great number of options, along with deciding how to arrange those components relative to one another.

Increasingly, it is desirable to display a design to a user, such as a designer or customer, before the eventual physical elements are manufactured and assembled. 3D computer graphics technologies, including virtual reality (VR) and augmented reality (AR), improve the user experience when viewing a design which is under development or complete. 3D models, or 3D computer graphics models, in this sense are mathematical representations of 3D objects (geometric data) for use by a computer for the purposes of performing calculations and rendering. Rendering of 3D models may generate 2D images for display (such as on a computer monitor) or actual 3D representations in the case of 3D printing.

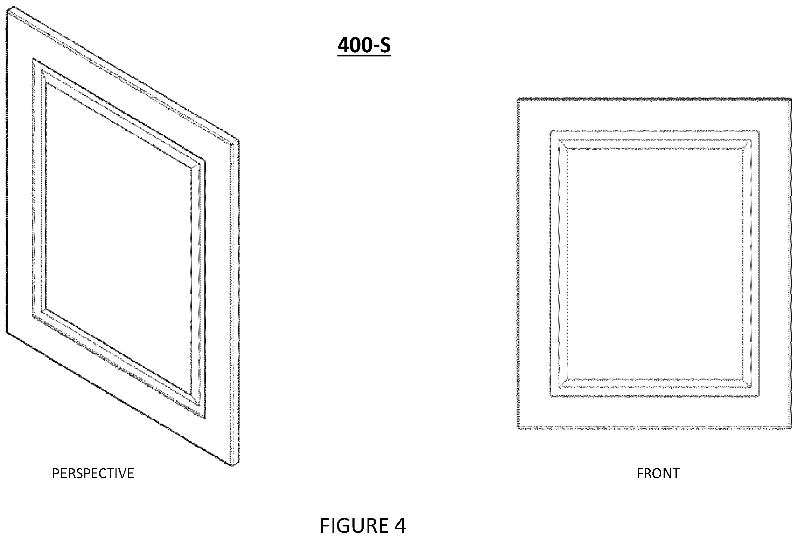

Kitchen unit frontals, such as kitchen unit doors, will be taken as a convenient running example in the context of kitchen design. Such frontals are typically intended to be offered in ranges, where the frontals of a given range are all of the same type but of differing sizes. Reference may be made for example to Figure 4, which will be referred to later, which shows an example 3D model of a frontal in 2D-rendered perspective and front views.

Typically, such 3D models are generated individually by an artist using 3D model design software such as Blender, the 3D computer graphics software toolset developed by the Blender Foundation, and rendered in Unity, the game engine developed by Unity Technologies (Unity Software Inc.). It is time-consuming for an artist to individually generate the 3D models for a given range - a typical range may comprise tens or hundreds of such frontals. The lead time to make a new range of frontals available as 3D models can be considerable and thus impact the ability of a designer/manufacturer to bring that new range to market quickly and efficiently.

It is desirable to provide improved 3D model generation systems, methods and software in the light of the above.

### SUMMARY

According to an embodiment of a first aspect of the present disclosure, there is provided a 3D model generation system comprising at least one computer, wherein: a procedural-rule generation application is configured to run on a given computer of the system; a model generation application is configured to run on said given computer or on another computer of the system; the procedural-rule generation application is configured, at runtime, to: receive portions of a source 3D model of a given object type; receive position information defining intended relative positions of those portions in a target 3D model of the given object type; receive or specify scaling rules associated with the portions, for scaling one or more of the respective portions when located in their intended relative positions to generate the target 3D model such that it has a target size whose value is an input parameter; and generate procedural rules, based on the portions, position information and scaling rules, for generation of the target 3D model based on a given value of the target size; and the model generation application is configured, at runtime, to: receive the procedural rules and an input value of the target size; and based on the received procedural rules and the input value, generate the target 3D model having the input value of the target size by procedural generation. Each said 3D model and portion of a 3D model may be defined as a mesh of polygons.

According to an embodiment of a second aspect of the present disclosure, there is provided a 3D model generation suite of computer programs, comprising: a procedural-rule generation application; and a model generation application, wherein: the procedural-rule generation application is configured, at runtime, to: receive portions of a source 3D model of a given object type; receive position information defining intended relative positions of those portions in a target 3D model of the given object type; receive or specify scaling rules associated with the portions, for scaling one or more of the respective portions when located in their intended relative positions to generate the target 3D model such that it has a target size whose value is an input parameter; and generate procedural rules, based on the portions, position information and scaling rules, for generation of the target 3D model based on a given value of the target size; and the model generation application is configured, at runtime, to: receive the procedural rules and an input value of the target size; and based on the received procedural rules and the input value, generate the target 3D model having the input value of the target size by procedural generation. Each said 3D model and portion of a 3D model may be defined as a mesh of polygons.

According to an embodiment of a third aspect of the present disclosure, there is provided a computer readable medium having one or both of the applications of the 3D model generation suite of computer programs of the aforementioned second aspect stored thereon.

According to an embodiment of a fourth aspect of the present disclosure, there is provided a computer-implemented 3D model generation method, comprising: receiving portions of a source 3D model of a given object type; receiving position information defining intended relative positions of those portions in a target 3D model of the given object type; receiving or specifying scaling rules associated with the portions, for scaling one or more of the respective portions when located in their intended relative positions to generate the target 3D model such that it has a target size whose value is an input parameter; generating procedural rules, based on the portions, position information and scaling rules, for generation of the target 3D model based on a given value of the target size; receiving an input value of the target size; and based on the procedural rules and the input value, generating the target 3D model having the input value of the target size by procedural generation. Each said 3D model and portion of a 3D model may be defined as a mesh of polygons.

According to an embodiment of a fifth aspect of the present disclosure, there is provided a procedural-rule generation system comprising at least one computer, wherein: a procedural-rule generation application is configured to run on a given computer of the system; and the procedural-rule generation application is configured, at runtime, to: receive portions of a source 3D model of a given object type; receive position information defining intended relative positions of those portions in a target 3D model of the given object type; receive or specify scaling rules associated with the portions, for scaling one or more of the respective portions when located in their intended relative positions to generate the target 3D model such that it has a target size whose value is an input parameter; and generate procedural rules, based on the portions, position information and scaling rules, for generation of the target 3D model based on a given value of the target size, wherein each said 3D model and portion of a 3D model is defined as a mesh of polygons.

According to an embodiment of a sixth aspect of the present disclosure, there is provided a procedural-rule generation application, configured, at runtime, to: receive portions of a source 3D model of a given object type; receive position information defining intended relative positions of those portions in a target 3D model of the given object type; receive or specify scaling rules associated with the portions, for scaling one or more of the respective portions when located in their intended relative positions to generate the target 3D model such that it has a target size whose value is an input parameter; and generate procedural rules, based on the portions, position information and scaling rules, for generation of the target 3D model based on a given value of the target size, wherein each said 3D model and portion of a 3D model is defined as a mesh of polygons.

### BRIEF DESCRIPTION OF THE FIGURES

Reference will now be made, by way of example, to the accompanying drawings, of which:
Figure 1 is a schematic diagram of a 3D model generation system 100 embodying the present invention;
Figure 2 is a flow diagram of a method carried out by the procedural-rule generation application PR of Figure 1;
Figure 3 is a flow diagram of a method carried out by the model generation application M of Figure 1;
Figure 4 is a schematic diagram of an example source 3D model in perspective and front views;
Figure 5 is a schematic diagram showing the front view of the source 3D model of Figure 4 along with three example target 3D models;
Figure 6 is a schematic diagram again showing the front view of the source 3D model of
Figure 4, overlain with dashed boxes indicating example portions;

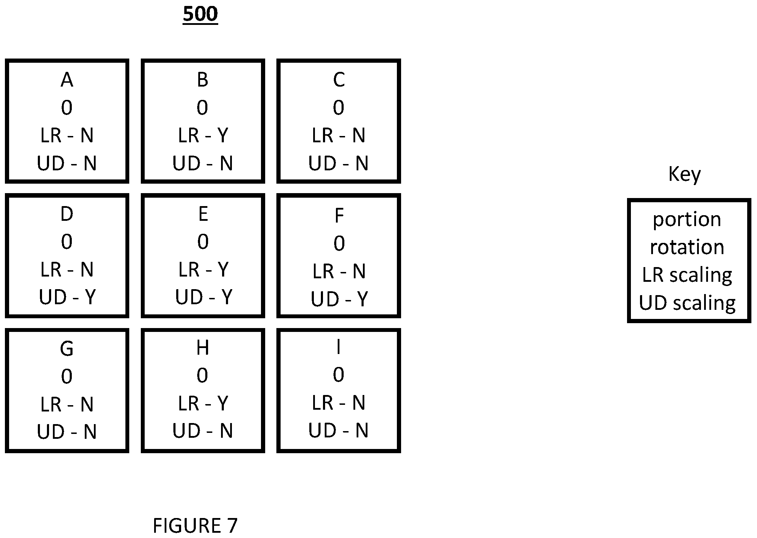

Figure 7 is a schematic diagram representative of an example graphical user interface;

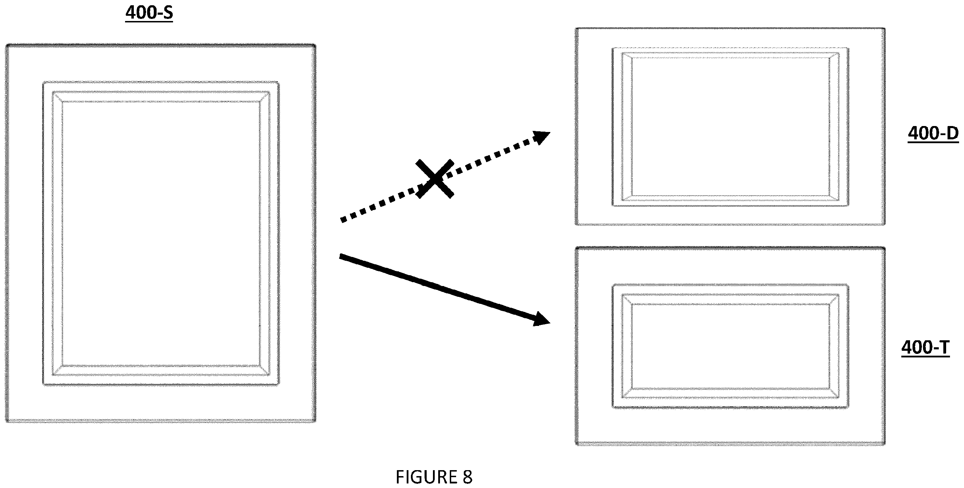

Figure 8 is a schematic diagram useful for understanding the importance of enabling one-dimensional scaling rules;

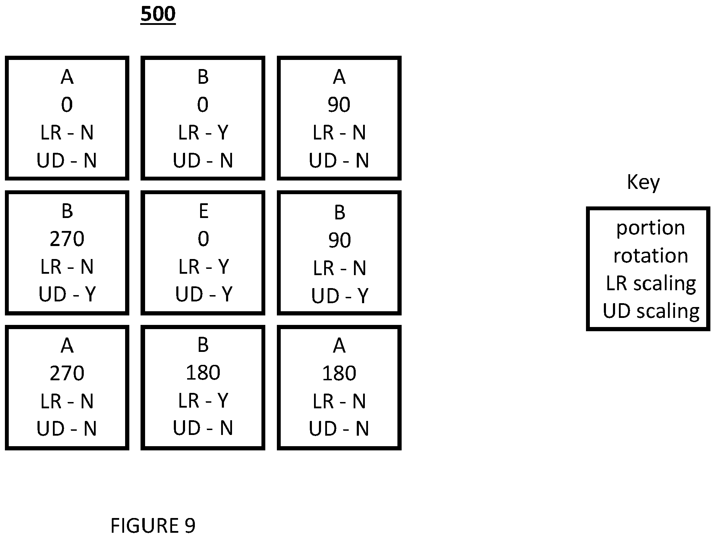

Figure 9 is a schematic diagram representative of an example graphical user interface;

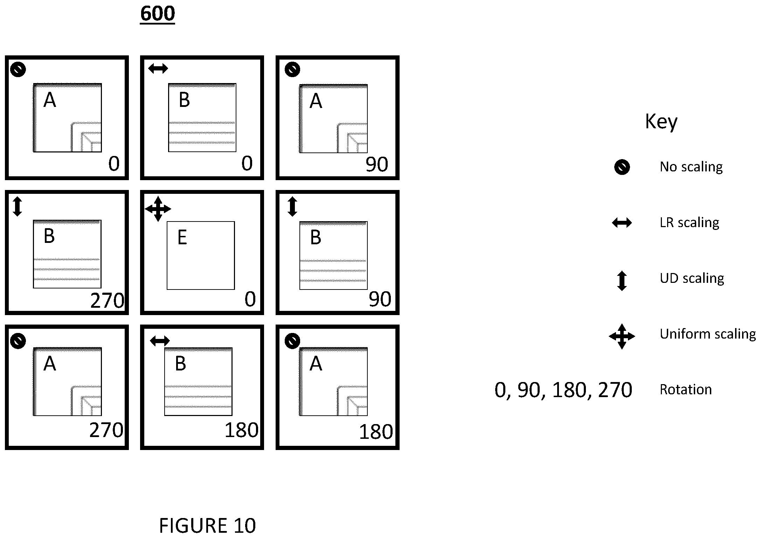

Figure 10 is a schematic diagram representative of an example graphical user interface;

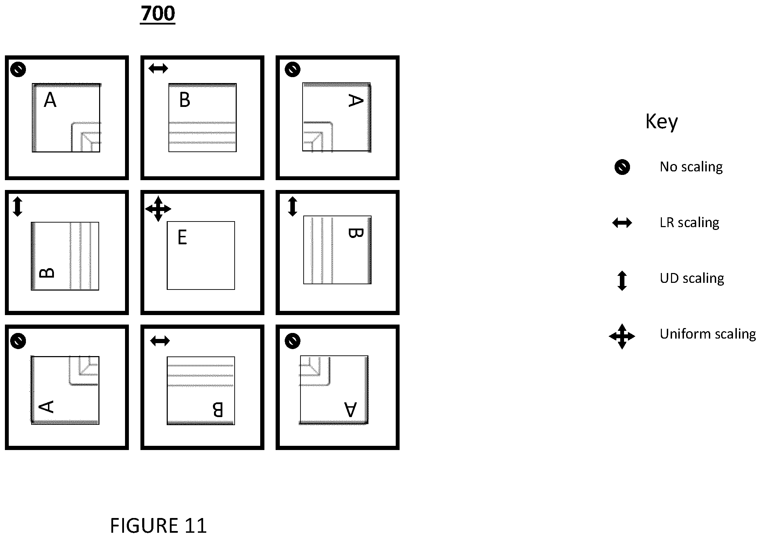

Figure 11 is a schematic diagram representative of an example graphical user interface;

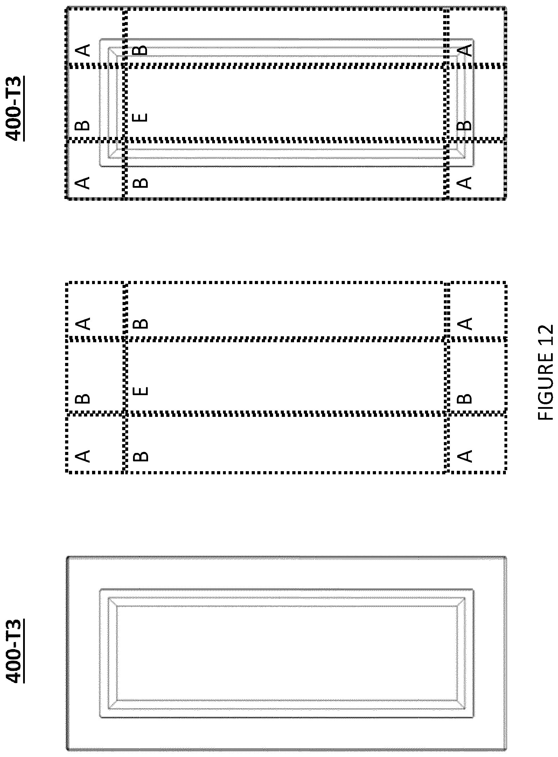

Figure 12 is a schematic diagram useful for understanding conceptually how a given target 3D model may have been generated by the model generation application M; and

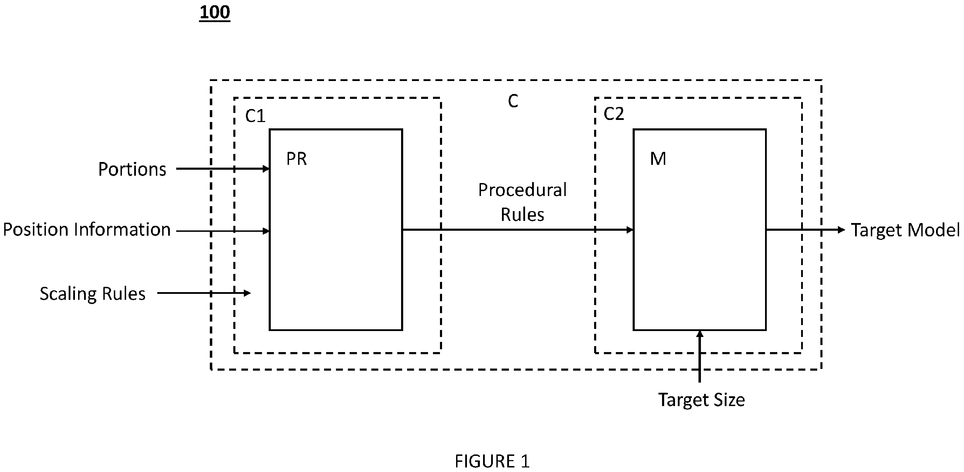

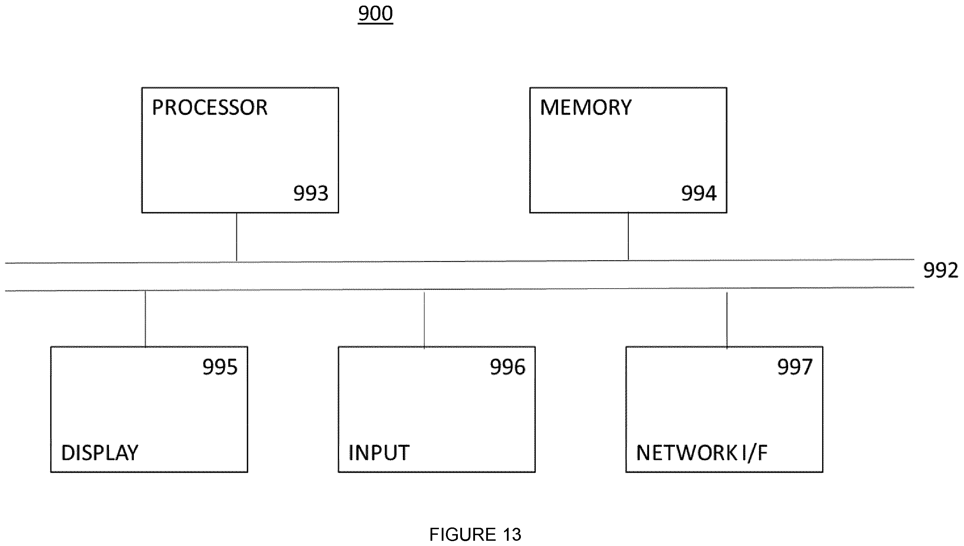

Figure 13 is a block diagram of a computing device which may serve as any of the computers of Figure 1.

### SPECIFIC DESCRIPTION

**Figure 1** is a schematic diagram of a 3D model generation system 100 embodying the present invention, being a computing system. The system 100 may comprise a single computer C or a plurality of computers C1 and C2 as indicated.

The system 100 comprises a procedural-rule generation application PR and a model generation application M. Although indicated as separate applications, the procedural-rule generation application PR and model generation application M may in some arrangements be provided as a single combined application.

The procedural-rule generation application PR is configured to run on a given computer of the system 100, such as on computer C1 or C as indicated. The model generation application M is also configured to run on a given computer of the system 100, such as on computer C2 or C. Thus, the procedural-rule generation application PR and the model generation application M may be configured to run on the same computer C as one another or on different computers C1 and C2.

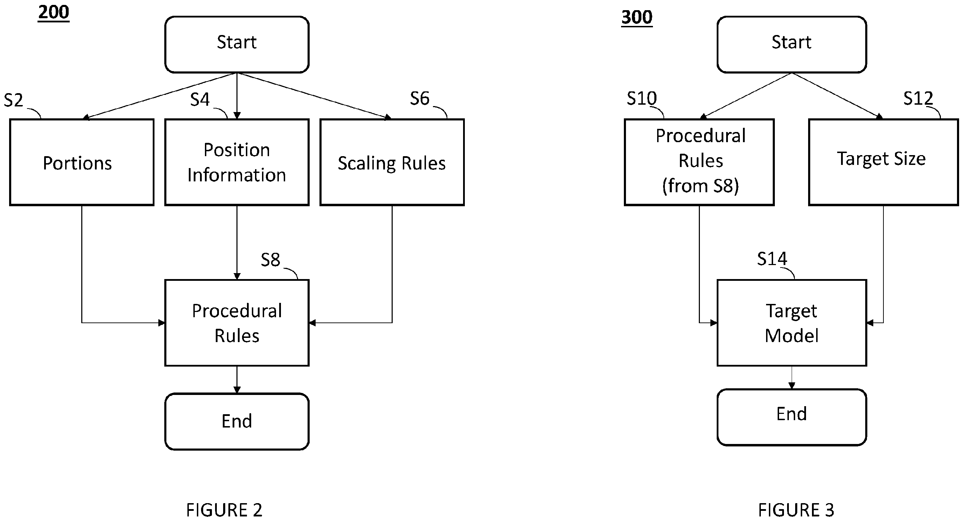

The system 100 may be better understood with reference to Figures 2 and 3. **Figure 2** is a flow diagram of a method 200 carried out at runtime by the procedural-rule generation application PR and **Figure 3** is a flow diagram of a method 300 carried out at runtime by the model generation application M.

Runtime may be understood as the period of time when an application or program is running or being executed. It begins when a program is opened (or executed) and ends with the program is quit or closed. When a program is in the runtime phase, the application may be loaded into RAM (random-access memory).

Starting with the procedural-rule generation application PR, the method 200 comprises steps S2, S4, S6 and S8.

The procedural-rule generation application PR is configured at step S2 to receive portions of a source 3D model of a given object type, at step S4 to receive position information defining intended relative positions of those portions in a target 3D model of the given object type, and at step S6 to receive or specify scaling rules associated with the portions, for scaling one or more of the respective portions when located in their intended relative positions to generate the target 3D model such that it has a target size whose value is an input parameter.

At step S8, the procedural-rule generation application PR is configured to generate procedural rules, based on the portions, position information and scaling rules, for generation of the target 3D model based on a given value of the target size.

As indicated in Figure 2, steps S2, S4 and S6 may be carried out in parallel, although they may in some arrangements be carried out sequentially. For example, in some arrangements the portions of the source 3D model may be received first in step S2 and then the position information may be provided by a user at step S4 in relation to the received portions. Similarly, in some arrangements the portions of the source 3D model may be received first in step S2 and then the scaling rules may be specified by a user at step S6 in relation to the received portions. In some arrangements, step S4 may follow step S2 and step S6 may follow step S4.

Turning to the model generation application M, the method 300 comprises steps S10, S12, and S14.

The model generation application M is configured at step S10 to receive the procedural rules and at step S12 to receive an input value of the target size (as a parameter value). At step 14, the model generation application M is configured, based on the received procedural rules and the input value, to generate the target 3D model having the input value of the target size by procedural generation. In this way, the target 3D model of the given object type is generated at a given size automatically, i.e. without an artist needing to individually generate or construct that model.

The target 3D model having the input value of the target size, when generated by the model generation application M at runtime by procedural generation, may be generated in memory (e.g. random-access memory or RAM) as a data representation of the 3D model. This memory used at runtime may be referred to as runtime memory. Such data representations may be exported as data files if desired. For example, a data file defining the target 3D model (having the input value of the target size) may be exported from the model generation application M (for use later by the model generation application M, or even by another application).

As mentioned earlier, **Figure 4** is a schematic diagram of an example source 3D model 400-S of a given object type, shown in perspective and front views.

The 3D models (computer graphics models) considered herein may be taken to be surface models (polygonal models, polygonal mesh models, shell models or boundary models), and to define the surface of the object concerned rather than its solid interior. Typically, such models use polygons to create a three-dimensional shape. The designed model is therefore composed of a plurality of polygons (or facets) that form a mesh (polygonal mesh, or triangulated mesh). Each polygon is composed of vertices, edges and faces. By assembling different polygons, the basic shape of the object (in Figure 4, a frontal) is obtained, in the same way that the interlocking of six square polygons will form a cube. In practice, the objects may be built up of triangular polygons (i.e. planar triangles with coplanar vertices and straight edges). Each 3D model and portion of a 3D model may thus be defined as a mesh of polygons, in practice triangular polygons or simply triangles. The user (or an application such as the model generation application M) can for example move edges and points in space to deform a model under construction to arrive at the desired 3D shape. 3D models, or 3D computer graphics models, in this sense are mathematical representations of 3D objects (geometric data) for use by a computer for the purposes of performing calculations and rendering. Rendering of 3D models ('3D rendering') may generate 2D images for display (such as on a computer monitor or display).

In line with the running example, model 400-S is of a frontal as may be applied to a kitchen unit. As can be seen from the model 400-S, the example frontal has a distinctive design - corresponding to the object type. The target 3D model here is another 3D model having the same distinctive design (i.e. of the same object type) and having a supplied value of the target size.

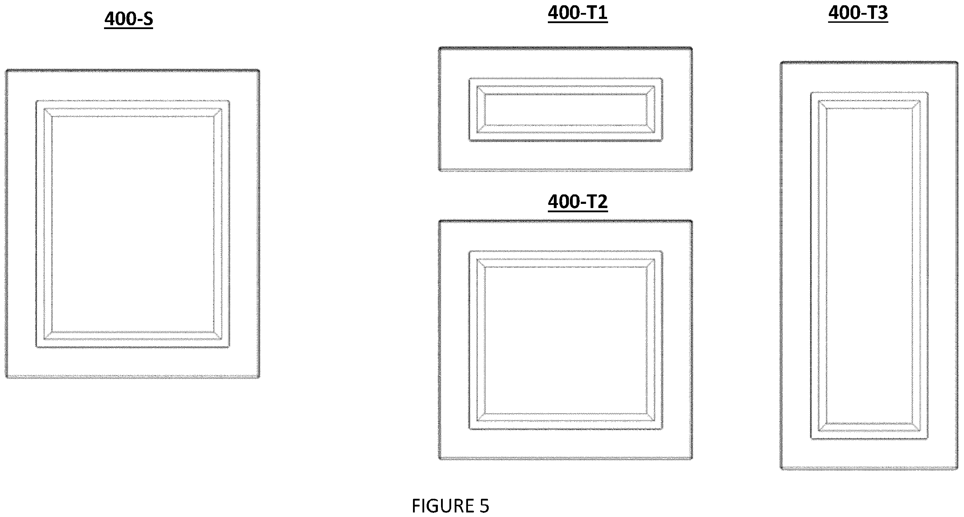

**Figure 5** is a schematic diagram showing the front view of the source 3D model 400-S, along with three example target 3D models 400-T1, 400-T2 and 400-T3 (also shown in front view) having different values of the target size. Each of the target 3D models 400-T1, 400-T2 and 400-T3 may be generically referred to as a target 3D model 400-T. All of the 3D models shown in Figure 5, i.e. 3D models 400-S, 400-T1, 400-T2 and 400-T3, have the same distinctive design as one another despite being of different sizes and thus may be considered all to be of the same object type. In the context of frontals as in this running example, these models represent frontals from the same frontal range.

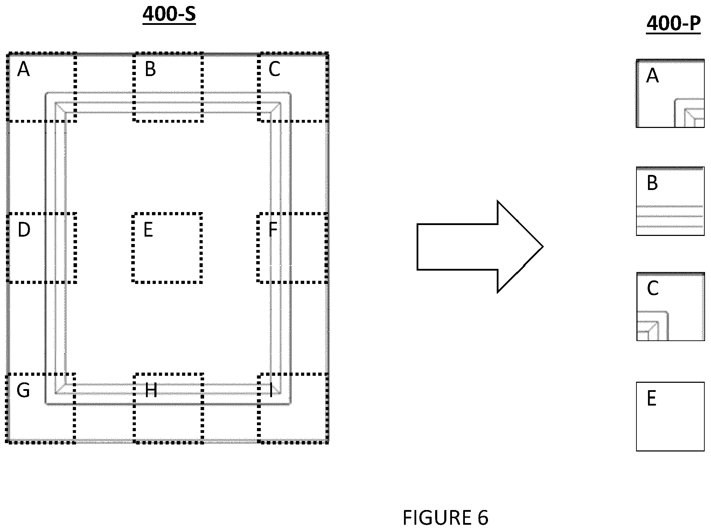

**Figure 6** is a schematic diagram again showing the front view of the source 3D model 400-S, overlain with dashed boxes labelled A to I indicating example portions of the source 3D model 400-S which may be received by the procedural-rule generation application PR in step S2. Also shown, on the right-hand side, are example portions A, B, C and E being simply some of the indicated portions A to I.

The portions could be generated effectively by slicing up the source 3D model 400-S (or defining or delimiting portions thereof) or could be separately generated (e.g. manually by an artist) as individual portions from the outset to correspond to the indicated portions of the intended source 3D model 400-S.

As will be appreciated from Figure 6, due to the symmetry present in the source 3D model 400-S it would be possible to generate any one of the target 3D models 400-T1, 400-T2 and 400-T3 of Figure 5 based on the portions A to I, albeit with some scaling (and translation) as considered later. Indeed, also as will be considered later, due to the symmetry present in the source 3D model 400-S it would be possible to generate any one of the target 3D models 400-T1, 400-T2 and 400-T3 of Figure 5 based on the portions A, B and E, albeit by using portions A and B multiple times and with some scaling and rotation (and translation) as considered later. Scaling, rotation and translation operations may be considered types of transform operation.

Although the procedural-rule generation application PR may be configured to receive the position information in step S4 and/or the scaling rules in step S6 by obtaining them from storage or from an input signal or similar, in some arrangements the procedural-rule generation application PR provides a graphical user interface to enable a user to provide the position information and/or to provide or specify the scaling rules.

In overview, such a graphical user interface may be configured to display selectable relative positions for model portions and receive the position information based on a user selecting at least one selectable relative position per portion, or a portion per selectable relative position. Such a graphical user interface may be configured to display selectable scaling rules for model portions or selectable relative positions and receive the scaling rules associated with the portions/positions based on a user selecting selectable scaling rules per portion or per selectable relative position having an associated portion.

**Figure 7** is a schematic diagram representative of a graphical user interface 500 which may be provided by the procedural-rule generation application PR.

The example graphical user interface 500 is configured to display selectable relative positions as cells in a grid, locations of the cells in the grid relative to one another corresponding to the locations of the relative positions relative to one another in the target 3D model (or in the source 3D model). In the example of Figure 7, nine such cells are displayed as respective squares laid out in a 3x3 grid. Of course, this is an example, and other girds having different numbers of cells, such as 3x5 or 7x2, may be provided. As a concrete example, it is assumed that the user has already associated the portions A to I of Figure 6 with the nine cells as indicated in Figure 7. In detail, portion A has been associated with the top-left cell, B with the top-centre cell, C with the top-right cell, D with the centre-left cell, E with the central cell, F with the centre-right cell, G with the bottom-left cell, H with the bottom-centre cell and I with the bottom-right cell. With this allocation, the locations of the cells in the grid relative to one another correspond to the relative positions of the portions in the source 3D model 400-S, and thus their intended relative positions in the target 3D model (see Figure 5).

It is also assumed that the user has already associated rotations with the portions A to I, by indicating that in the respective cells. In detail, because all of the portions A to I have been used, a 0 degree rotation has been associated with each of the portions A to I. In such a situation, it may not be necessary to specify rotational information (given that no rotational information is needed, or in that the applied rotation is uniform).

The graphical user interface 500 is also configured to display selected scaling rules in association with the cells in the grid to associate selected scaling rules with corresponding portions. In the example of Figure 7, portion A has been associated with no scaling (i.e. left-right scaling = no, or LR-N, and up-down scaling = no, or UD-N), B with scaling only in the horizontal dimension (i.e. left-right scaling = yes, or LR-Y, and UD-N), C with no scaling (i.e. LR-N and UD-N), D with scaling only in the vertical dimension (i.e. LR-N, and up-down scaling = yes, or UD-Y), E with uniform scaling (i.e. LR-Y and UD-Y), F with scaling only in the vertical dimension (i.e. LR-N and UD-Y), G with no scaling (i.e. LR-N and UD-N), H with scaling only in the horizontal dimension (i.e. LR-Y and UD-N) and I with no scaling (i.e. LR-N and UD-N). With this allocation, and looking back to the portions of Figure 6, it can be seen that portions scaled in this way could be used to generate any of the target 3D models 400-T1, 400-T2 and 400-T3 of Figure 5 given a corresponding input value of the target size.

The horizontal and vertical dimensions in the Figures may be considered first and second dimensions for the following, with the third dimension being into and out of the page.

In the allocation of scaling rules in the example of Figure 7, note that portions B, D, F and H have been allocated one-dimensional scaling rules (i.e. scaling in the other two dimensions is locked or set to factor 1). The one-dimensional scaling rules may be considered non-uniform scaling rules since the scaling differs between the first and second dimensions. The portion E has been allocated two-dimensional scaling rules (i.e. scaling in the other dimension is locked or set to factor 1). The two-dimensional scaling rules may be considered non-uniform scaling rules when the scaling factor differs between the first and second dimensions or uniform scaling rules when the scaling factor is the same between the first and second dimensions. Given the running example of frontals, it is assumed that no scaling is desired in the third dimension and the present examples will be understood accordingly (although when other objects are modelled scaling in the third dimension may also need to be specified). Portions A, C, G and I have been allocated no scaling (i.e. scaling in all three dimensions is locked or set to factor 1), and this may be considered a type of uniform scaling.

Thus, for at least one relative position in the example target 3D model 400-T, the scaling rules define its portion as a scaled portion and are configured to scale that portion in at least one of the first, second and third dimensions of the target 3D model 400-T. For example, the scaling rules are configured to scale portions B and H in (only) the first dimension and portions D and F in (only) the second dimension. It is recalled that for frontals it is assumed that no scaling is desired in the third dimension.

Similarly, for at least one relative position in the target 3D model 400-T, the scaling rules define its portion as a one-dimensional scaled portion and define one-dimensional scaling of that portion. As above, the scaling rules are configured to scale portions B and H in (only) the first dimension and portions D and F in (only) the second dimension. As can be seen, for at least one relative position in the target 3D model 400-T where the scaling rules define its portion as a one-dimensional scaled portion, the scaling rules define that portion as being scaled in one of the first and second dimensions of the target 3D model and as not being scaled in the other one of the first and second dimensions of the target 3D model.

For at least one relative position in the target 3D model 400-T, the scaling rules define its portion as a two-dimensional scaled portion and define two-dimensional scaling of that portion across the first and second dimensions of the target 3D model. For example, the scaling rules are configured to scale portion E uniformly or non-uniformly (depending on the target size) in both the first and second dimensions. For at least one relative position in the target 3D model, the scaling rules define its portion as a non-scaled portion and define that portion as not being scaled in the first and second (and third) dimensions of the target 3D model. For example, the scaling rules are configured to not scale portions A, C, G and I.

**Figure 8** is a schematic diagram useful for understanding the importance of enabling one-dimensional scaling rules for certain portions, or for enabling different scaling rules for different portions. It can be seen that by applying the scaling rules of Figure 7 to the portions of Figure 6 the target 3D model 400-T shown on the bottom right can be generated to represent the same object type as the source 3D model 400-S shown on the left-hand side. If, however, the source 3D model 400-S or all of the portions were to be scaled uniformly or in the same way as one another, a distorted 3D model 400-D as shown on the top right would be obtained and this would not represent the same object type as the source 3D model 400-S.

Looking back at Figure 7, although not shown in that example, the received position information may define at least one received portion as having at least two intended relative positions in the target 3D model 400-T so that that at least one received portion is employed at least twice (e.g. by cloning or copying) in generating the target 3D model. In this way, the amount of storage capacity needed to store the portions is reduced.

With this in mind, **Figure 9** is another schematic diagram representative of the graphical user interface 500 but showing a different allocation of portions to the cells (with associated changes to the rotational information and scaling rules).

In the example of Figure 9, it is assumed that the user has already associated the portions A, B and E of Figure 6 with the nine cells as indicated. Note that portions C, D, F, G, H and I are not needed due to the symmetry of the source 3D model 400-S. In detail, and measuring rotation in the clockwise direction, portion A (with 0 degrees rotation) has been associated with the top-left cell, B (with 0 degrees rotation) with the top-centre cell, A (with 90 degrees rotation) with the top-right cell, B (with 270 degrees rotation) with the centre-left cell, E (with 0 degrees rotation) with the central cell, B (with 90 degrees rotation) with the centre-right cell, A (with 270 degrees rotation) with the bottom-left cell, B (with 180 degrees rotation) with the bottom-centre cell and A (with 180 degrees rotation) with the bottom-right cell. The scaling rule allocation per cell is the same as for Figure 7.

With these allocations, and looking back to the portions of Figure 6 as before, it can be seen that portions scaled in this way could be used to generate any of the target 3D models 400-T1, 400-T2 and 400-T3 of Figure 5 given a corresponding input value of the target size.

Indeed, looking back at Figures 1 and 3, the model generation application M may be configured, at runtime, to receive a plurality of input values for the target size, and, based on the received procedural rules and the plurality of input values of the target size, to generate a plurality of target 3D models (e.g. the target 3D models 400-T1, 400-T2 and 400-T3 of Figure 5) having the respective (different) input values of the target size by procedural generation. In this way, any number of such target 3D models could be generated, corresponding in the running example to a partial or even full range of frontals.

For example, such a number of such target 3D models could be generated by procedural generation when (taking the example of kitchen frontals) generating a 3D environment representing an entire kitchen comprising many frontals from the same range but of different sizes. The model portions concerned could be stored once in memory and referenced multiple times to generate the range of target 3D models needed and ultimately the desired 3D environment in a memory-efficient and time-efficient manner. For example, it may be quicker to procedurally generate the models rather than download them (or otherwise access them) from a library of models.

Of course, the arrangement of the graphical user interface 500 of Figures 7 and 9 is an example. **Figure 10** is a schematic diagram representative of a graphical user interface 600, showing the same allocation of portions to cells as in Figure 9 but in a different way as indicated by the key provided alongside the graphical user interface 600. To better give the user a feel for the target 3D modes 400-T, the portions associated with the cells are represented graphically in the cells rather than by simple letter label (e.g. A to I) as before. **Figure 11** is a schematic diagram representative of a graphical user interface 700, showing the same allocation of portions to cells as in Figures 9 and 10 but in still a different way as indicated by the key provided alongside the graphical user interface 600. The portions associated with the cells are represented graphically in the cells rather than by label (e.g. A to I) as before. However, rather than indicate rotations numerically as in Figure 10, in Figure 11 the graphical representations themselves have been rotated.

**Figure 12** is a schematic diagram useful for understanding conceptually how a given target 3D model 400-T, in this case target 3D model 400-T3 from Figure 5, may have been generated by the model generation application M based on the procedural rules and an input value of the target size (as a parameter value).

The target 3D model 400-T3 is shown as generated on the left-hand side and then with overlayed portions on the right-hand side corresponding to the allocation of portions in Figures 9 to 11. The layout of portions itself is then shown in the centre without details of the structure of the portions themselves.

By comparing Figures 12 and 6, for example, it can be seen that the various portions concerned (or copies or clones or instances thereof) have been positioned relative to one another, rotated and scaled as indicated in in Figures 9 to 11 to generate the target 3D model 400-T3, based on an input value of the target size (as a parameter value) which has defined its overall size. It will be appreciated that such transform operations (translation, rotation and/or scaling) may correspond to updating, adjusting the positions of vertices (and/or edges) of polygons of the portions concerned or clones thereof. That is, new positions of vertices (and/or edges) may be calculated in such operations.

The scaling may be implemented based on an algorithm which for example places the corner portions (A in Figure 12) in their correct positions relative to one another given the input value of the target size, scales the edge portions (B in Figure 12) until they meet the corner portions, and then scales the central portion (E in Figure 12) to meet the surrounding portions. The algorithm may for example be based on the size of the portions of the source 3D model 400-S and the input value of the target size.

As a concrete example, the portions may all have a defined "standard" size, e.g. corresponding to 1cm by 1cm in the first and second dimensions (ignoring the third dimension in the case of the example frontals). The model generation application M may be configured to point to the portions in memory and apply transform operations (translation, rotation, scaling) as appropriate and defined in the procedural rules to arrive at the target 3D model. For example, the portions may be imported at a common origin position and translated to the correct location in the model coordinate system or model space (and rotated and/or scaled as necessary).

The procedural-rule generation application PR and the model generation application M may be configured to handle UV mapping as well as the basic geometry of the 3D models.

As is well known, UV mapping is the 3D modelling process of projecting a 2D image onto the surface of a 3D model for texture mapping. The letters "U" and "V" here denote the axes (or dimensions) of the 2D texture in texture space (or UV space) where "X", "Y", and "Z" are used to denote the axes (or dimensions) of the 3D model in model space. UV texturing enables polygons that make up a 3D model to be "painted" with colour (and other surface attributes) from a 2D image, called a UV texture map. When a 3D model is created as a polygon mesh as described herein, UV coordinates (also known as texture coordinates) can be generated for each vertex in the mesh in order to map the 2D texture to the 3D model.

With this in mind, the portions may be considered to each comprise (or define) a portion-based mapping of UV coordinates to coordinates of the portion concerned. The procedural-rule generation application PR may be configured, at runtime, to define in the procedural rules, based on the portions, position information and scaling rules, rules for adjusting the portion-based mapping to a model-based mapping of UV coordinates to coordinates of the target 3D model (i.e. in model space) based on the given value of the target size. The model generation application M may be configured, at runtime, based on the received procedural rules and the input value (of the target size), to generate the target 3D model with the model-based mapping of UV coordinates to coordinates of the target 3D model.

Looking at Figure 12, and taking a simplified example, an individual portion A may map its bottom left corner to 0,0 in UV space and its top right corner to 1,1 in UV space (considering the UV space to range from 0 to 1 in each dimension). The model generation application M may adjust this portion-based mapping to model-based mapping when generating the target 3D model 400-T3, such that for the target 3D model 400-T3 when viewed as a whole its bottom left corner is mapped to 0,0 in UV space and its top right corner to 1,1. For example, looking at the bottom left portion A in the target 3D model 400-T3, its bottom left corner may be mapped to 0,0 in UV space and its top right corner to 0.3,0.1. As another example, looking at the top right portion A in the target 3D model 400-T3, its bottom left corner may be mapped to 0.7,0.9 in UV space and its top right corner to 1,1. In this way, when the target 3D model 400-T3 is rendered (using a UV texture map) it may appear as a continuous, unified 3D model rather than as a grouping of model portions.

The procedural rules themselves may be generated in any format known to the procedural-rule generation application PR and the model generation application M. For example, the human-readable JSON (JavaScript Object Notation) format may be used with the model generation application M comprising a JSON parser. As another example, a memory-ready binary file format could be used.

The procedural-rule generation application PR and the model generation application M may be provided as a suite of computer programs, for example on a computer readable medium. Of course, the procedural-rule generation application PR and the model generation application M may be provided individually on separate computer readable media.

**Figure 13** is a block diagram of a computing device 900, which may serve as any of the computers C, C1, C2 of Figure 1, and which may be used to implement any of the methods disclosed herein. The computing device comprises a processor 993, and memory, 994. Optionally, the computing device also includes a network interface 997 for communication with other computing devices, for example with other computing devices to connect computers C1 and C2 of Figure 1.

For example, an embodiment may be composed of a network of such computing devices (e.g. C1 and C2). Optionally, the computing device also includes one or more input mechanisms such as keyboard and mouse 996, and a display unit such as one or more monitors 995. The components are connectable to one another via a bus 992.

The memory 994 may include a computer readable medium, which term may refer to a single medium or multiple media (e.g., a centralized or distributed database and/or associated caches and servers) configured to carry computer-executable instructions or have data structures stored thereon. Computer-executable instructions may include, for example, instructions and data accessible by and causing a general purpose computer, special purpose computer, or special purpose processing device (e.g., one or more processors) to perform one or more functions or operations. Thus, the term "computer-readable storage medium" may also include any medium that is capable of storing, encoding or carrying a set of instructions for execution by the machine and that cause the machine to perform any one or more of the methods of the present disclosure. The term "computer-readable storage medium" may accordingly be taken to include, but not be limited to, solid-state memories, optical media and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

The processor 993 is configured to control the computing device and execute processing operations, for example executing code stored in the memory to implement the various different functions of the methods, modules, units, and applications described here and in the claims. The memory 994 stores data being read and written by the processor 993. As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an application specific integrated circuit (ASIC), a field programmable gate array (FPGA), a digital signal processor (DSP), network processor, or the like. In one or more embodiments, a processor is configured to execute instructions for performing the operations and steps discussed herein.

The display unit 997 may display a representation of data stored by the computing device and may also display a cursor and dialog boxes and screens enabling interaction between a user and the programs and data stored on the computing device. For example, the display unit 997 may display a graphical user interface as described above. The input mechanisms 996 may enable a user to input data and instructions to the computing device, for example to enable interaction with a graphical user interface as described above.

The network interface (network I/F) 997 may be connected to a network, such as the Internet, and is connectable to other such computing devices via the network. The network I/F 997 may control data input/output from/to other apparatus via the network. Other peripheral devices such as microphone, speakers, printer, power supply unit, fan, case, scanner, trackerball etc may be included in the computing device.

In any of the above aspects, the various features may be implemented in hardware, or as software modules running on one or more processors/computers. References herein to applications may be understood as references to computer applications, software applications, computer programs and/or software.

The invention also provides a computer program or a computer program product comprising instructions which, when executed by a computer, cause the computer to carry out any of the methods/method steps described herein, and a non-transitory computer-readable medium comprising instructions which, when executed by a computer, cause the computer to carry out any of the methods/method steps described herein. A computer program embodying the invention may be stored on a non-transitory computer-readable medium, or it could, for example, be in the form of a signal such as a downloadable data signal provided from an Internet website, or it could be in any other form.

In general, the various exemplary embodiments may be implemented in hardware or special purpose circuits, software, logic or any combination thereof. For example, some aspects may be implemented in hardware, while other aspects may be implemented in firmware or software which may be executed by a controller, microprocessor or other computing device, although the disclosure is not limited thereto. While various aspects of the exemplary embodiments of this disclosure may be illustrated and described as block diagrams, flow charts, or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

As such, it should be appreciated that at least some aspects of the exemplary embodiments of the disclosure may be practiced in various components such as integrated circuit chips and modules. It should thus be appreciated that the exemplary embodiments of this disclosure may be realized in an apparatus that is embodied as an integrated circuit, where the integrated circuit may comprise circuitry (as well as possibly firmware) for embodying at least one or more of a data processor, a digital signal processor, baseband circuitry and radio frequency circuitry that are configurable so as to operate in accordance with the exemplary embodiments of this disclosure.

It should be appreciated that at least some aspects of the exemplary embodiments of the disclosure may be embodied in computer-executable instructions, such as in one or more program modules, executed by one or more computers or other devices. Generally, program modules include routines, programs, objects, components, data structures, etc. that perform particular tasks or implement particular abstract data types when executed by a processor in a computer or other device. The computer executable instructions may be stored on a computer readable medium such as a hard disk, optical disk, removable storage media, solid state memory, RAM, etc. As will be appreciated by one of skill in the art, the function of the program modules may be combined or distributed as desired in various embodiments. In addition, the function may be embodied in whole or in part in firmware or hardware equivalents such as integrated circuits, field programmable gate arrays (FPGA), and the like.

References in the present disclosure to "one embodiment", "an embodiment" and so on, indicate that the embodiment described may include a particular feature, structure, or characteristic, but it is not necessary that every embodiment includes the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to implement such feature, structure, or characteristic in connection with other embodiments whether or not explicitly described.

It should be understood that, although the terms "first", "second" and so on may be used herein to describe various elements, these elements should not be limited by these terms. These terms are only used to distinguish one element from another. For example, a first element could be termed a second element, and similarly, a second element could be termed a first element, without departing from the scope of the disclosure. As used herein, the term "and/or" includes any and all combinations of one or more of the associated listed terms.

The terminology used herein is for the purpose of describing particular embodiments only and is not intended to limit the present disclosure. As used herein, the singular forms "a", "an" and "the" are intended to include the plural forms as well, unless the context clearly indicates otherwise. It will be further understood that the terms "comprises", "comprising", "has", "having", "includes" and/or "including", when used herein, specify the presence of stated features, elements, and/or components, but do not preclude the presence or addition of one or more other features, elements, components and/ or combinations thereof. The terms "connect", "connects", "connecting" and/or "connected" used herein cover the direct and/or indirect connection between two elements.

The present disclosure includes any novel feature or combination of features disclosed herein either explicitly or any generalization thereof. Various modifications and adaptations to the foregoing exemplary embodiments of this disclosure may become apparent to those skilled in the relevant arts in view of the foregoing description, when read in conjunction with the accompanying drawings. However, any and all modifications will still fall within the scope of the non-limiting and exemplary embodiments of this disclosure.

The present invention may be embodied in many different ways in the light of the above disclosure, within the spirit and scope of the appended claims.

The present disclosure extends to the following statements:
S1. A 3D model generation system comprising at least one computer, wherein:
   a procedural-rule generation application is configured to run on a given computer of the system;
   a model generation application is configured to run on said given computer or on another computer of the system;
   the procedural-rule generation application is configured, at runtime, to:
      receive portions of a source 3D model of a given object type;
      receive position information defining intended relative positions of those portions in a target 3D model of the given object type;
      receive or specify scaling rules associated with the portions, for scaling one or more of the respective portions when located in their intended relative positions to generate the target 3D model such that it has a target size whose value is an input parameter; and
      generate procedural rules, based on the portions, position information and scaling rules, for generation of the target 3D model based on a given value of the target size; and
      the model generation application is configured, at runtime, to:
         receive the procedural rules and an input value of the target size; and
         based on the received procedural rules and the input value, generate the target 3D model having the input value of the target size by procedural generation,
         optionally wherein each said 3D model and portion of a 3D model is defined as a mesh of polygons or is a surface model or a boundary model or a polygonal mesh model.
S2. The 3D model generation system according to statement S1, wherein:
   the source 3D model has a source size and the scaling rules are based on the source and target sizes, optionally based on a difference between the source and target sizes; and/or
   the procedural-rule generation application is configured, at runtime, to determine sizes of the portions, and the scaling rules are based on the sizes of the portions and optionally the target size; and/or
   the model generation application is configured, when generating the target 3D model, to calculate positions (in model space) of vertices of the polygons of the portions or clones thereof based on the procedural rules (and the input value of the target size).
S3. The 3D model generation system according to statement S1 or S2, wherein the procedural rules comprise:
   for at least one relative position, rules for generating the portion concerned or a clone or scaled version thereof; and/or
   for at least one relative position, rules for obtaining the portion concerned from storage and generating the target 3D model based on the obtained portion or a clone thereof.
S4. The 3D model generation system according to any of the preceding statements, wherein the received position information defines at least one received portion as a multiuse portion having at least two intended relative positions in the target 3D model so that that at least one received portion is employed at least twice in generating the target 3D model.
S5. The 3D model generation system according to statement S5, wherein the model generation application is configured, when generating the target 3D model, to store only one instance of said multiuse portion in memory in respect of its at least two intended relative positions in the target 3D model and reference that multiuse portion at least twice when generating the target 3D model.
S6. The 3D model generation system according to any of the preceding statements, wherein the position information defines transform operations to be applied to the portions or clones thereof to generate the target 3D model,
   optionally wherein the transform operations comprise a rotation and/or a translation.
S7. The 3D model generation system according to any of the preceding statements, wherein, for at least one relative position in the target 3D model, the scaling rules define its portion as a scaled portion and define scaling of that portion or a clone thereof in at least one of first, second and third dimensions of the target 3D model.
S8. The 3D model generation system according to statement S7, wherein, for at least one relative position in the target 3D model, the scaling rules define its portion as a one-dimensional scaled portion and define one-dimensional scaling of that portion or a clone thereof across the first and second dimensions of the target 3D model.
S9. The 3D model generation system according to statement S8, wherein, for at least one relative position in the target 3D model where the scaling rules define its portion as a one-dimensional scaled portion, the scaling rules define that portion or a clone thereof as being scaled in one of the first and second dimensions of the target 3D model and as not being scaled in the other one of the first and second dimensions of the target 3D model.
S10. The 3D model generation system according to any of statements S7 to S9, wherein, for at least one relative position in the target 3D model, the scaling rules define its portion as a two-dimensional scaled portion and define two-dimensional scaling of that portion or a clone thereof in the first and second dimensions of the target 3D model.
S11. The 3D model generation system according to any of statements S7 to S10, wherein, for at least one relative position in the target 3D model, the scaling rules define its portion as a non-scaled portion and define that portion or a clone thereof as not being scaled in the first and second dimensions of the target 3D model.
S12. The 3D model generation system according to any of the preceding statements, wherein:
   the received portions each comprise a portion-based mapping of UV coordinates to coordinates of the portion concerned;
   the procedural-rule generation application is configured, at runtime, to define in said procedural rules, based on the portions, position information and scaling rules, rules for adjusting the portion-based mapping to a model-based mapping of UV coordinates to coordinates of the target 3D model based on the given value of the target size; and
   the model generation application is configured, at runtime, based on the received procedural rules and the input value, to generate the target 3D model with the model-based mapping of UV coordinates to coordinates of the target 3D model.
S13. The 3D model generation system according to any of the preceding statements, wherein the model generation application is configured, at runtime, to:
   receive a plurality of input values for the target size; and
   based on the received procedural rules and the plurality of input values of the target size, generate a plurality of target 3D models having the respective input values of the target size by procedural generation.
S14. The 3D model generation system according to any of the preceding statements, wherein the procedural-rule generation application is configured, at runtime, to provide a graphical user interface, the graphical user interface configured to receive the position information defining the intended relative positions of the portions and the scaling rules associated with the portions based on user inputs.
S15. The 3D model generation system according to statement S14, wherein the graphical user interface is configured to:
   display selectable relative positions for model portions and receive the position information based on a user selecting at least one selectable relative position per portion or a portion per selectable relative position; and
   display selectable scaling rules for model portions or selectable relative positions and receive the scaling rules associated with the portions based on a user selecting selectable scaling rules per portion or per selectable relative position having an associated portion.
S16. The 3D model generation system according to statement S14 or S15, wherein the graphical user interface is configured to display the selectable relative positions as cells in a grid, locations of the cells in the grid relative to one another corresponding to the locations of the relative positions relative to one another in the target 3D model.
S17. The 3D model generation system according to any of statements S14 to S16, wherein the graphical user interface is configured to display selected scaling rules in association with the cells in the grid to associate selected scaling rules with corresponding portions.
S18. A 3D model generation suite of computer programs, comprising:
   a procedural-rule generation application; and
   a model generation application,
   wherein:
      the procedural-rule generation application is configured, at runtime, to:
         receive portions of a source 3D model of a given object type;
         receive position information defining intended relative positions of those portions in a target 3D model of the given object type;
         receive or specify scaling rules associated with the portions, for scaling one or more of the respective portions when located in their intended relative positions to generate the target 3D model such that it has a target size whose value is an input parameter; and
         generate procedural rules, based on the portions, position information and scaling rules, for generation of the target 3D model based on a given value of the target size; and
      the model generation application is configured, at runtime, to:
         receive the procedural rules and an input value of the target size; and
         based on the received procedural rules and the input value, generate the target 3D model having the input value of the target size by procedural generation,
         wherein each said 3D model and portion of a 3D model is defined as a mesh of polygons.
S19. A computer readable medium having one or both of the applications of the 3D model generation suite of computer programs of statement S18 stored thereon.
S20. A computer-implemented 3D model generation method, comprising:
   receiving portions of a source 3D model of a given object type;
   receiving position information defining intended relative positions of those portions in a target 3D model of the given object type;
   receiving or specifying scaling rules associated with the portions, for scaling one or more of the respective portions when located in their intended relative positions to generate the target 3D model such that it has a target size whose value is an input parameter;
   generating procedural rules, based on the portions, position information and scaling rules, for generation of the target 3D model based on a given value of the target size;
   receiving an input value of the target size; and
   based on the procedural rules and the input value, generating the target 3D model having the input value of the target size by procedural generation,
   wherein each said 3D model and portion of a 3D model is defined as a mesh of polygons.
S21. A procedural-rule generation system comprising at least one computer, wherein:
   a procedural-rule generation application is configured to run on a given computer of the system; and
   the procedural-rule generation application is configured, at runtime, to:
      receive portions of a source 3D model of a given object type;
      receive position information defining intended relative positions of those portions in a target 3D model of the given object type;
      receive or specify scaling rules associated with the portions, for scaling one or more of the respective portions when located in their intended relative positions to generate the target 3D model such that it has a target size whose value is an input parameter; and
      generate procedural rules, based on the portions, position information and scaling rules, for generation of the target 3D model based on a given value of the target size,
      wherein each said 3D model and portion of a 3D model is defined as a mesh of polygons.
S22. A procedural-rule generation application, configured, at runtime, to:
   receive portions of a source 3D model of a given object type;
   receive position information defining intended relative positions of those portions in a target 3D model of the given object type;
   receive or specify scaling rules associated with the portions, for scaling one or more of the respective portions when located in their intended relative positions to generate the target 3D model such that it has a target size whose value is an input parameter; and
   generate procedural rules, based on the portions, position information and scaling rules, for generation of the target 3D model based on a given value of the target size,
   wherein each said 3D model and portion of a 3D model is defined as a mesh of polygons.

## Claims

1. A 3D model generation system comprising at least one computer, wherein:
a procedural-rule generation application is configured to run on a given computer of the system;
a model generation application is configured to run on said given computer or on another computer of the system;
the procedural-rule generation application is configured, at runtime, to:
receive portions of a source 3D model of a given object type;
receive position information defining intended relative positions of those portions in a target 3D model of the given object type;
receive or specify scaling rules associated with the portions, for scaling one or more of the respective portions when located in their intended relative positions to generate the target 3D model such that it has a target size whose value is an input parameter; and
generate procedural rules, based on the portions, position information and scaling rules, for generation of the target 3D model based on a given value of the target size; and
the model generation application is configured, at runtime, to:
receive the procedural rules and an input value of the target size; and
based on the received procedural rules and the input value, generate the target 3D model having the input value of the target size by procedural generation,
wherein each said 3D model and portion of a 3D model is defined as a mesh of polygons.

2. The 3D model generation system as claimed in claim 1, wherein:
the source 3D model has a source size and the scaling rules are based on the source and target sizes, optionally based on a difference between the source and target sizes; and/or
the procedural-rule generation application is configured, at runtime, to determine sizes of the portions, and the scaling rules are based on the sizes of the portions and optionally the target size.

3. The 3D model generation system as claimed in claim 1 or 2, wherein the procedural rules comprise:
for at least one relative position, rules for generating the portion concerned or a clone or scaled version thereof; and/or
for at least one relative position, rules for obtaining the portion concerned from storage and generating the target 3D model based on the obtained portion or a clone thereof.

4. The 3D model generation system as claimed in any of the preceding claims, wherein the received position information defines at least one received portion as a multiuse portion having at least two intended relative positions in the target 3D model so that that at least one received portion is employed at least twice in generating the target 3D model.

5. The 3D model generation system as claimed in claim 5, wherein the model generation application is configured, when generating the target 3D model, to store only one instance of said multiuse portion in memory in respect of its at least two intended relative positions in the target 3D model and reference that multiuse portion at least twice when generating the target 3D model.

6. The 3D model generation system as claimed in any of the preceding claims, wherein the position information defines transform operations to be applied to the portions or clones thereof to generate the target 3D model,
optionally wherein the transform operations comprise a rotation and/or a translation.

7. The 3D model generation system as claimed in any of the preceding claims, wherein, for at least one relative position in the target 3D model, the scaling rules define its portion as a scaled portion and define scaling of that portion or a clone thereof in at least one of first, second and third dimensions of the target 3D model.

8. The 3D model generation system as claimed in claim 7, wherein, for at least one relative position in the target 3D model, the scaling rules define its portion as a one-dimensional scaled portion and define one-dimensional scaling of that portion or a clone thereof across the first and second dimensions of the target 3D model.

9. The 3D model generation system as claimed in claim 8, wherein, for at least one relative position in the target 3D model where the scaling rules define its portion as a one-dimensional scaled portion, the scaling rules define that portion or a clone thereof as being scaled in one of the first and second dimensions of the target 3D model and as not being scaled in the other one of the first and second dimensions of the target 3D model.

10. The 3D model generation system as claimed in any of claims 7 to 9, wherein, for at least one relative position in the target 3D model, the scaling rules define its portion as a two-dimensional scaled portion and define two-dimensional scaling of that portion or a clone thereof in the first and second dimensions of the target 3D model.

11. The 3D model generation system as claimed in any of claims 7 to 10, wherein, for at least one relative position in the target 3D model, the scaling rules define its portion as a non-scaled portion and define that portion or a clone thereof as not being scaled in the first and second dimensions of the target 3D model.

12. The 3D model generation system as claimed in any of the preceding claims, wherein:
the received portions each comprise a portion-based mapping of UV coordinates to coordinates of the portion concerned;
the procedural-rule generation application is configured, at runtime, to define in said procedural rules, based on the portions, position information and scaling rules, rules for adjusting the portion-based mapping to a model-based mapping of UV coordinates to coordinates of the target 3D model based on the given value of the target size; and
the model generation application is configured, at runtime, based on the received procedural rules and the input value, to generate the target 3D model with the model-based mapping of UV coordinates to coordinates of the target 3D model.

13. The 3D model generation system as claimed in any of the preceding claims, wherein the model generation application is configured, at runtime, to:
receive a plurality of input values for the target size; and
based on the received procedural rules and the plurality of input values of the target size, generate a plurality of target 3D models having the respective input values of the target size by procedural generation.

14. The 3D model generation system as claimed in any of the preceding claims, wherein the procedural-rule generation application is configured, at runtime, to provide a graphical user interface, the graphical user interface configured to receive the position information defining the intended relative positions of the portions and the scaling rules associated with the portions based on user inputs.

15. A 3D model generation suite of computer programs, comprising:
a procedural-rule generation application; and
a model generation application,
wherein:
the procedural-rule generation application is configured, at runtime, to:
receive portions of a source 3D model of a given object type;
receive position information defining intended relative positions of those portions in a target 3D model of the given object type;
receive or specify scaling rules associated with the portions, for scaling one or more of the respective portions when located in their intended relative positions to generate the target 3D model such that it has a target size whose value is an input parameter; and
generate procedural rules, based on the portions, position information and scaling rules, for generation of the target 3D model based on a given value of the target size; and
the model generation application is configured, at runtime, to:
receive the procedural rules and an input value of the target size; and
based on the received procedural rules and the input value, generate the target 3D model having the input value of the target size by procedural generation,
wherein each said 3D model and portion of a 3D model is defined as a mesh of polygons.
